# EUROPEAN PATENT APPLICATION

(11) **EP 4 589 848 A1**
(43) Date of publication of application: **23.07.2025**
(21) Application number: 24386004.6
(22) Date of filing: 16.01.2024
(51) Int. Cl.: H03M 1/06, H03M 1/10, H03M 1/12

(54) **TIME-INTERLEAVED ANALOGUE-TO-DIGITAL CONVERTERS (ADCS)**

(71) Applicant: Hamilton Sundstrand Corporation, Charlotte, NC 28217 (US)
(72) Inventor: SKOULAXINOS, Stefanos, Huntington Cannock, WS12 4UR (GB); BEDDER, Ian, Stoney Stanton Leicester, LE9 4WH (GB)
(74) Representative: Dehns

(57) **Abstract**

A time-interleaved analogue-to-digital converter (1) including a first analogue-to-digital converter (2a) and a second analogue-to-digital converter (2b), each arranged to sample a respective analogue input (4) periodically and produce a respective digital output (8a, 8b) based on the sampled analogue input (4), and also including a signal interleaving portion (10), arranged to combine the digital outputs (8a, 8b) to produce a digital output signal (14). The time-interleaved analogue-to-digital converter (1) is configured for operation both in an operational mode and a calibration mode. In the operational mode, the second analogue-to-digital converter (2b) is arranged to sample the analogue input (4) a first time period after the first analogue-to-digital converter (2a) samples the analogue input (4). In the calibration mode, the second analogue-to-digital converter (2b) is arranged to sample the analogue input (4) simultaneously with the first analogue-to-digital converter (2a), or a second time period apart from a time at which the first analogue-to-digital converter (2a) samples the analogue input (4), wherein the second time period is shorter than the first time period.

## Description

### Technical field

This disclosure relates to a time-interleaved analogue-to-digital converter and a method of operating a time-interleaved analogue-to-digital converter.

### Background

An analogue-to-digital converter (ADC) is a system that converts an analogue signal into a digital signal. It is known to arrange several analogue to digital converters in parallel, each sampling at different instants, and then to combine their outputs together to reconstruct an output signal which is the digitized analogue input of the ADC (e.g. by plotting a graph of each output relative to its respective sampling time). This "time-interleaved" arrangement of ADCs achieves a higher throughput of the overall arrangement without increasing the clock frequency of the individual ADCs. This is effective since there is a fundamental limit to the maximum sampling rate of a single ADC.

However, whilst interleaved ADCs provide advantages, sampling the same analogue signal with multiple ADCs is likely to introduce some artefacts into the data. For example, tolerances of the analogue passive circuitry around the ADCs and ADC manufacturing process variations may lead to the interleaved sampled data exhibiting minor differences in terms of offset, gain and sample timing.

Offset refers to a uniform shifting of the digital output of the time-interleaved ADC either upwards or downwards relative to the analogue input. Gain refers to a scaling error, proportional to the size of the analogue input, such that the gradient of an output slope does not match the gradient of the analogue input. Timing skew refers to an error in which one or more of the ADCs sample not quite at the intended time, i.e. slightly earlier or slightly later than they should do.

It is a goal of the present disclosure to provide a time-interleaved analogue-to-digital converter which addresses some of these shortcomings.

### Summary

According to a first aspect of this disclosure, there is provided a time-interleaved analogue-to-digital converter comprising:
a first analogue-to-digital converter, arranged to sample an analogue input periodically and produce a digital output based on the sampled analogue input;
a second analogue-to-digital converter, arranged to sample the analogue input periodically and produce a digital output based on the sampled analogue input; and
a signal interleaving portion, arranged to combine the digital outputs from the first analogue-to-digital converter and the second analogue-to-digital converter to produce a digital output signal;

the time-interleaved analogue-to-digital converter configured for operation both in an operational mode and in a calibration mode;
wherein, in the operational mode, the second analogue-to-digital converter is arranged to sample the analogue input a first time period after the first analogue-to-digital converter samples the analogue input; and
wherein, in the calibration mode, the second analogue-to-digital converter is arranged to sample the analogue input simultaneously with the first analogue-to-digital converter sampling the analogue input; or
wherein, in the calibration mode, the second analogue-to-digital converter is arranged to sample the analogue input a second time period apart from a time at which the first analogue-to-digital converter samples the analogue input, wherein the second time period is shorter than the first time period.

According to a second aspect of this disclosure, there is provided a method of operating a time-interleaved analogue-to-digital converter, the time-interleaved analogue-to-digital converter comprising:
a first analogue-to-digital converter, arranged to sample an analogue input periodically according to a first set of sample timings and produce a digital output based on the sampled analogue input;
a second analogue-to-digital converter, arranged to sample the analogue input periodically according to a second set of sample timings and produce a digital output based on the sampled analogue input; and
a signal interleaving portion, arranged to combine the digital outputs from the first analogue-to-digital converter and the second analogue-to-digital converter to produce a digital output signal;
comprising:
in a calibration mode, adjusting the first set of sample timings and/or the second set of sample timings such that the first analogue-to-digital converter and the second analogue-to-digital converter sample the analogue input closer together in time than during normal operation of the time-interleaved analogue-to-digital converter.

In some examples, the method may comprise in the calibration mode, adjusting the first set of sample timings and/or the second set of sample timings such that the first analogue-to-digital converter and the second analogue-to-digital converter sample the analogue input simultaneously.

By altering the times at which the individual analogue-to-digital converters of the time-interleaved analogue-to-digital converter sample in the calibration mode, such that they sample the analogue signal closer together in time (possibly even simultaneously) accurate calibration of the analogue-to-digital converters (ADCs) with each other is enabled. The closer together in time the analogue-to-digital converters take their samples, the more similar the values of the analogue input at the time of each sample are likely to be. This ensures that most (or all) of the difference between the digital outputs of the analogue-to-digital converters is a result of errors or mismatches between them, rather than a result of changes in the value of the analogue input between sample times. These differences between analogue-to-digital converters can then be removed by calibrating each device, e.g. by altering its operation or applying one or more adjustments to its respective digital output.

It will be understood that although referred to herein simply as analogue-to-digital converters of the time-interleaved analogue-to-digital converter, these individual analogue-to-digital converters which together provide the time-interleaved analogue-to-digital converter may also be referred to as sub-analogue-to-digital converters - since they together provide the overall analogue-to-digital conversion function of the time-interleaved analogue-to-digital converter.

In some examples, the first set of sample timings is based on (e.g. responsive to) a first timing signal and the second set of sample timings is based on a second timing signal. Thus, in some examples, each analogue-to-digital converter is arranged to sample an analogue input periodically based on a respective timing signal, i.e. each analogue-to-digital converter samples in accordance with a periodic timing signal. During normal operation these timing signals are out of sync, such that each analogue-to-digital converter samples at a different instant, separated by the second time period. It will be understood, as set out above, that during operation in the calibration mode these sample timings (e.g. timing signals) are brought closer (or even fully) into alignment with each other such that the analogue-to-digital converters sample the analogue input closer in time to each other, optionally simultaneously.

In some examples, the sampling frequency (i.e. the rate of sampling) is the same for each analogue-to-digital converter in the calibration mode and in the operational mode (i.e. the change causes a time shift in the relative sampling times, but does not change the frequency at which each particular analogue-to-digital converter samples the analogue input).

It will be understood that each analogue-to-digital converter generally takes samples of the analogue signal periodically, and therefore repeatedly. Therefore, where reference is made to one analogue-to-digital converter sampling a signal a certain time period apart from, or before or after, another analogue-to-digital converter samples the analogue input, it will be understood that this refers to the closest (preceding or following) time at which that analogue-to-digital converter samples the signal, e.g. a time at which the first analogue-to-digital converter samples the analogue input refers to the closest point in time (the nearest instant) at which the first analogue-to-digital converter samples the analogue input.

It is stated that the analogue-to-digital converters sample closer together in time during operation in the calibration mode than during normal operation. Normal operation may also be referred to as the operational mode. Normal operation refers to use of the time-interleaved analogue-to-digital converter in its intended manner, to convert an analogue signal to a digital output, in typical operational conditions, e.g. not testing conditions.

In some examples, in the calibration mode, the second analogue-to-digital converter is arranged to sample the analogue input (substantially) simultaneously with the first analogue-to-digital converter sampling the analogue input. Similarly, in some examples, the method comprises, in a calibration mode, adjusting the first sample timings and/or the second sample timings such that the first analogue-to-digital converter and the second analogue-to-digital converter sample the analogue input (substantially) simultaneously. The time-interleaved analogue-to-digital converter may comprise more than two analogue-to-digital converters, and in the calibration mode all of the analogue-to-digital converters may be arranged to sample the analogue input (substantially) simultaneously.

Simultaneously sampling the input with the first and second analogue-to-digital converters helps to ensure that both analogue-to-digital converters are sampling an analogue input with substantially the same value, such that any difference between their digital outputs is not due to a difference on the input side. This allows the analogue-to-digital converters to be calibrated particularly accurately and effectively. It will be understood that simultaneous sampling does not require perfect simultaneity, which is unlikely to be possible in reality due to system errors, but rather requires sampling to be simultaneous within normal tolerance and error ranges.

In some examples, the time-interleaved analogue-to-digital converter is configured for operation in the calibration mode during a period of time in which an expected value of the analogue input is known. By expected it is meant that the value of the analogue input is predictable in this time period with reasonable accuracy, for example based on previously collected data or based on operating principles.

In some examples, the time-interleaved analogue-to-digital converter is configured for operation in the calibration mode during power-up of the time-interleaved analogue-to-digital converter. Similarly, in some examples the method comprises operating the time-interleaved analogue-to-digital converter in the calibration mode during power-up of the time-interleaved analogue-to-digital converter. During a brief period after power-up of the device, it may be receiving no external input, such that the analogue input has an expected value of 0V. Since the value of the analogue input is known (i.e. predicted, expected), the digital outputs of the analogue-to-digital converters can be compared to the expected value of the analogue input, and any deviation from the expected value can be attributed to calibration errors of the respective analogue-to-digital converter.

In some examples, the time-interleaved analogue-to-digital converter is configured for operation in the calibration mode during power-up of an analogue system connected to the analogue input (i.e. arranged to supply an output analogue signal to the analogue input of the time-interleaved analogue-to-digital converter). Similarly, in some examples the method comprises operating the time-interleaved analogue-to-digital converter in the calibration mode during power-up of the analogue system. Sampling at the appropriate time, to coincide with power-up of the analogue system, may be achieved by sampling at a known delay, or by supplying a synchronisation signal to the time-interleaved analogue-to-digital converter. Thus, the period of time in which an expected value of the analogue input is known and in which sampling is carried out for calibration purposes may be when the ADC system comes online or when the analogue system, supplying the signal for conversion, comes online.

In some examples, the time-interleaved analogue-to-digital converter is configured, for a single calibration process, to operate in the calibration mode for a pre-defined time period (for a given system), e.g. for a few milliseconds. By this it will be understood that the time-interleaved analogue-to-digital converter only needs to carry out the simultaneous (or closer together in time) sampling for at least this pre-defined time period to obtain sufficient data to usefully calibrate the analogue-to-digital converters on a particular occasion. Many such calibration processes may be carried out over the lifetime of the device.

In some examples, the method is a method of calibrating the time-interleaved analogue-to-digital converter. By calibrating will be understood comparing measurement values output by the analogue-to-digital converters of the time-interleaved analogue-to-digital converter, so as to determine variations in the measurement outputs that they provide. Calibration may also include adjustment of the operation of one or more of the analogue-to-digital converters, and/or adjustment of the digital output values of one or more of the analogue-to-digital converters, such that their outputs, for the same input, are closer together or optionally the same.

Thus, in some examples, the time-interleaved analogue-to-digital converter is configured to derive respective calibration corrections (e.g. for gain and/or offset) for the first and second analogue-to-digital converters based on the digital outputs of the first and second analogue-to-digital converters produced in the calibration mode. Calibration corrections will be understood as adjustments (e.g. numerical adjustments) to be made to a particular analogue-to-digital converter or its digital output to correct its digital output so that it more accurately reflects the analogue input.

In some examples, the time-interleaved analogue-to-digital converter is configured to derive the calibration corrections for each of the analogue-to-digital converters by comparing the digital outputs of the first and second analogue-to-digital converters. Thus, some controllers (e.g. more complex controllers) may be able to derive some information in relation to the outputs of the different analogue-to-digital converters even without knowing the value of the analogue input.

In some examples, the time-interleaved analogue-to-digital converter is configured to derive the calibration corrections for each of the analogue-to-digital converters by calculating the adjustment needed to bring the digital outputs of the first and second analogue-to-digital converters into alignment with (e.g. to have the same value as) an expected value of the analogue signal (e.g. the expected value of the analogue signal during the period of operation in the calibration mode).

In some examples, the time-interleaved analogue-to-digital converter is configured to apply the derived calibration corrections to the digital outputs of the first and second analogue-to-digital converters during operation in the operational mode. Thus, having derived calibration corrections based on the simultaneous (or closer together in time) sampling, the time-interleaved analogue-to-digital converter then applies the derived calibrations corrections to their associated analogue-to-digital converter or its digital output, during later, normal operation of the device. This provides more accurate digital outputs from each analogue-to-digital converter, and therefore from the digital output signal of the overall time-interleaved analogue-to-digital converter.

In some examples, the time-interleaved analogue-to-digital converter is configured to receive at least one calibration voltage signal at the analogue input. Thus, the time-interleaved analogue-to-digital converter is arranged to sometimes receive an external calibration signal. As explained further below, this external calibration voltage signal may allow further calibration and/or improved, more accurate calibration of the time-interleaved analogue-to-digital converter.

The time-interleaved analogue-to-digital converter may be configured to receive the at least one calibration voltage signal at the analogue input, whilst operating in the calibration mode described above (i.e. sampling closer together in time or simultaneously with its analogue-to-digital converters) or it may be configured to receive the at least one calibration voltage signal in a secondary calibration mode (i.e. separate to the calibration mode). In the secondary calibration mode, the second analogue-to-digital converter may be arranged to sample the analogue input a second time period apart from a time at which the first analogue-to-digital converter samples the analogue input (i.e. as in the operational mode) or may be arranged to sample the analogue input a third time period apart from a time at which the first analogue-to-digital converter samples the analogue input. The third time period may be shorter or longer than the second time period.

Thus the at least one calibration voltage signal may be received at the analogue input simultaneously or concurrently with operation in the calibration mode, or sequentially with operation in the calibration mode, i.e. one after the other, or further alternatively the mode of operation may be carried out separately, i.e. independently.

In some examples, the calibration voltage signal comprises a gain-and/or-offset-calibration signal, wherein the gain-and/or-offset-calibration signal has at least two different values, at different times, and wherein the time-interleaved analogue-to-digital converter is configured to derive (secondary) calibration corrections for gain and/or offset for the first and second analogue-to-digital converters based on comparing the digital outputs of the first and second analogue-to-digital converters with the corresponding value of the gain-and/or-offset-calibration signal.

The gain-and/or-offset-calibration signal may be a stepped-signal, i.e. having a series of sequentially increasing or decreasing values, with a sharp transition between adjacent values. By sharp transition it is meant that the time between the signal having first value and a next, second value is much shorter than the time for which the signal has either the first value or the second value.

Calibrating for gain and/or offset using an externally supplied signal allows calibration to be carried out on-demand, rather than only in periods in which the analogue input has an expected value. It may also provide more reliable calibration. Calibration using the calibration voltage signal may be used together with or as an alternative to sampling during a period in which the analogue input has an expected value.

As described above, the sampling of the voltage calibration signal may be carried out in the calibration mode (i.e. during the time in which the time-interleaved analogue-to-digital converter is operated in the calibration mode), and therefore may be carried out closer together in time (or simultaneously), as described above.

Alternatively, for the gain-and/or-offset-calibration signal described above, the sampling of the gain-and/or-offset-calibration signal may be carried out in addition to the calibration mode sampling described above. It may be sampled with the same time intervals as are used in the operational mode, or using samples separated by a third time period as described above. Since the value of the gain-and/or-offset-calibration signal (over time) is known, it is less important for the analogue-to-digital converters to take their samples close together in time.

In some examples, the time-interleaved analogue-to-digital converter is arranged to apply the derived (secondary) calibration corrections (for gain and/or offset) to the respective digital outputs of the first and second analogue-to-digital converters. It will be appreciated that these (secondary) calibration corrections derived using the gain- and/or-offset-calibration signal may override calibration corrections determined according to the above method in which the analogue input is sampled closer together in time in a period in which it has an expected value (and vice-versa). The time-interleaved analogue-to-digital converter may also use the most recently derived calibration corrections. Alternatively, the calibration corrections derived from these methods may be combined in any other suitable manner, e.g. by averaging.

In some examples, in addition or alternatively, the calibration voltage signal comprises a sloped time-calibration signal. The time-interleaved analogue-to-digital converter may be configured to derive a timing correction for the first and/or second analogue-to-digital converter based on comparing digital outputs of the first and second analogue-to-digital converters, output based on samples of the time-calibration signal taken at different times. The time-interleaved analogue-to-digital converter may be arranged to take at least three samples of the time-calibration signal to determine the timing correction(s) (e.g. two with the first analogue-to-digital converter and one with the second, or one with the first analogue-to-digital converter and one with a third analogue-to-digital converter to determine a timing error with the second analogue-to-digital converter).

By a sloped signal it will be understood that the signal has a non-zero, constant gradient, such that the time-calibration signal is either uniformly increasing or uniformly decreasing over time.

By sampling the time-calibration signal at different times with each of the analogue-to-digital converters, timing skew of one of the analogue-to-digital converters (in which the analogue-to-digital converter does not sample precisely at the expected time instant) may be detected. In some examples, the time-interleaved analogue-to-digital converter is further configured to adjust sample timings at which the first analogue-to-digital converter and/or the second analogue-to-digital converter sample the analogue input based on the derived timing corrections. This may be done by adjusting the first timing signal and/or the second timing signal, or by applying a correction or shift to the first timing signal and/or the second timing signal.

The calibration voltage signal may be supplied to the analogue input by an external device. The calibration voltage signal may be supplied during initial testing or configuration of the time-interleaved analogue-to-digital converter, e.g. in a laboratory or factory. Additionally or alternatively, the time-interleaved analogue-to-digital converter may be arranged so that it is possible to supply the calibration voltage signal to the analogue input during the operational lifetime of the device, in order to maintain the calibrations of the respective analogue-to-digital converters over the course of operation of the time-interleaved analogue-to-digital converter. Thus, in some examples, there is further provided a voltage source arranged to supply the at least one calibration voltage signal (e.g. the gain-and/or-offset-calibration signal and/or the sloped time-calibration signal), to the analogue input. The voltage source may be a digital-to-analogue converter (DAC).

According to a third aspect of the present disclosure, there is provided a time-interleaved analogue-to-digital converter calibration system, comprising:
the time-interleaved analogue-to-digital converter as described above; and
a voltage source, arranged to supply the at least one calibration voltage signal to the analogue input of the time-interleaved analogue-to-digital converter.

It will be appreciated that where the time-interleaved analogue-to-digital converter (or components thereof) are described as being configured to carry out certain steps, the method may likewise comprise the corresponding step. Similarly, the device may be configured to carry out any of the method steps referred to above.

### Detailed description

Certain preferred examples of this disclosure will now be described, by way of example only, with reference to the accompanying drawings, in which:
Figure 1 is a schematic diagram of a time-interleaved ADC to which the invention may be applied;
Figure 2 is a diagram showing the sample timings of the time-interleaved ADC of Figure 1 during normal operation;
Figure 3 is a diagram representing calibration of the ADC signals according to the present disclosure;
Figure 4 is a schematic diagram of a field programmable gate array, demonstrating how gain and offset calibration may be achieved;
Figure 5 is a graph illustrating a calibration method which uses an input calibration voltage signal to calibrate for gain and offset;
Figures 6 and 7 illustrate a calibration method which may be used in addition to the calibration method of Figure 3, which uses an input calibration voltage signal to calibrate for timing skew;
Figure 8 is a schematic diagram of a field programmable gate array, demonstrating how timing skew correction may be achieved; and
Figure 9 is a flow chart showing a method according to the present disclosure.

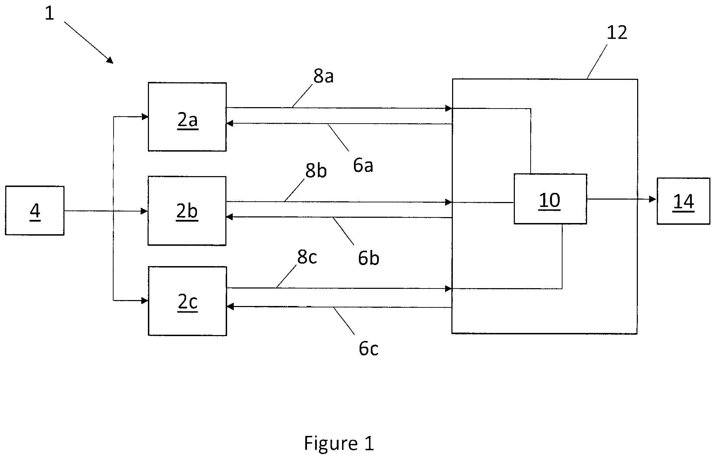

Figure 1 shows a time-interleaved analogue-to-digital converter 1. Analogue-to-digital converter may be abbreviated to ADC. In this example, the time-interleaved ADC 1 includes three individual analogue-to-digital converters - a first ADC 2a, a second ADC 2b, and a third ADC 2c. The time-interleaved ADC 1 receives a sampled analogue signal at its analogue input 4.

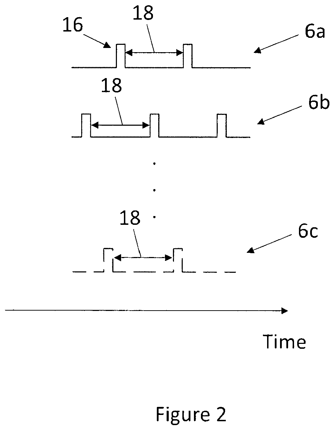

In this example, each ADC 2a, 2b, 2c receives a corresponding individual timing signal 6a, 6b, 6c which dictates the sample timings (i.e. when and at what frequency) with which that ADC samples the analogue input 4. A first timing signal 6a is provided to the first ADC 2a, and likewise for the other two. These timing signals 6a, 6b, 6c, also referred to as sampling clocks, are shown in greater detail in Figure 2, and are described further below.

Each ADC 2a, 2b, 2c produces a respective digital output 8a, 8b, 8c based on the analogue input 4. These signals are interleaved by a signal interleaving portion 10, so as to reconstruct a digital output signal 14 which encodes the analogue input 4. In particular, the signals are interleaved by charting each digital output 8a, 8b, 8c, relative to its respective sample time, to give an overall digital output signal 14. In this example the signal interleaving portion 10 is located within a field programmable gate array (FPGA) or a digital signal processor (DSP) 12.

Example timing signals 6a, 6b, 6c during normal operation of the time-interleaved ADC are represented in Figure 2.

The sharp peaks or spikes 16 in each timing signal trigger the corresponding ADC 2a, 2b, 2c to sample the analogue input 4. Since these timing signals 6a, 6b, 6c trigger the associated ADC to sample the analogue input 4, they dictate, and therefore represent, the sample timings of each ADC (i.e. the frequency, period, and relative time offset of sampling).

As can be seen, the timing signals 6a, 6b, 6c are staggered in time relative to each other, so that each ADC 2a, 2b, 2c is sampling the analogue signal 4 at a different time (i.e. non-simultaneously). Although only three ADCs are shown in this example, and therefore only three timing signals are shown, it will be appreciated that more (or only two) may be present in other examples. The possibility for additional timing signals to be present is indicated in Figure 2 by the ellipsis. In this example, each timing signal 6a, 6b, 6c (and therefore the sample timing of each ADC) has the same frequency and therefore the same period 18 between samples for a particular ADC.

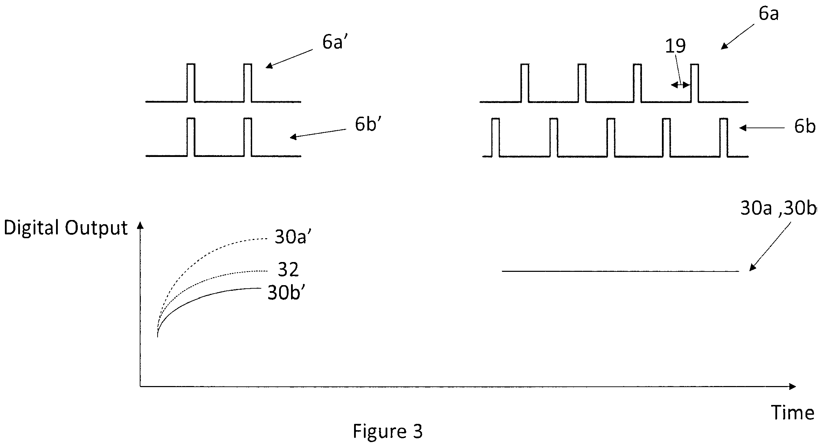

The mode in which the ADCs 2a, 2b, 2c are operated with these staggered, equally separated timing signals may be referred to as the "operational mode" of the time-interleaved ADC. It represents the period in which the time-interleaved ADC carries out normal operation. Operation in the operational mode is illustrated on the right-hand side of Figure 3, which shows timing signals 6a, 6b (and therefore sample timings), and corresponding digital output signals 30a, 30b, of two of the ADCs 2a, 2b.

According to the present disclosure, the time-interleaved ADC 1 is also operable in a calibration mode, as represented on the left-hand side of Figure 3.

The upper part of Figure 3 represents the timing signals for the first and second ADCs 2a, 2b, with the timing signals 6a', 6b' on the left relating to timing in the calibration mode, and the timing signals 6a, 6b on the right relating to timing in the operational mode. The lower part of the Figure is a graph representing the digital outputs 30a, 30b, 30a', 30b' of the first and second ADCs during the calibration period (left) and the operational period (right).

The calibration mode may be activated during a period in which the expected value of the analogue input 4 and therefore the expected value of the digital outputs of the ADCs is known. For example, calibration mode may be activated in the period immediately following power up of the device containing the time-interleaved ADC 1. This expected digital output value 32 is represented by a dotted line in Figure 3.

In this example, during, or immediately after, the calibration period (i.e. the operation of the time-interleaved ADC in the calibration mode), the time-interleaved ADC 1 derives a respective gain and an offset correction (i.e. a calibration correction) for each of the ADCs 2a, 2b, 2c individually, based on comparing their digital outputs 30a', 30b' with the expected digital output 32. The period in which the calibration corrections are calculated, and any necessary adjustments stored, may be referred to as the "adjustment period".

In the calibration mode, the usual (i.e. operational mode) timing signals are not used for triggering sampling of the ADCs. Instead, in this example, all of the ADCs 2a, 2b, 2c of the time-interleaved ADC 1 are supplied with identical, aligned timing signals, causing them to all sample the analogue input 4 simultaneously. Thus, the sample timings of all the ADCs 2a, 2b, 2c are brought into alignment. Arranging all of the ADCs 2a, 2b, 2c to sample simultaneously, rather than in a staggered way, improves the accuracy and reliability of the calibration process. This advantage may still be (at least partially) achieved, by bringing the sample timing of the ADCs 2a, 2b, 2c closer together in time, even where entirely simultaneous sampling of the analogue input 4 is not possible. In such a case the sampling times of the ADCs 2a, 2b, 2c will still be separated by a time period (a second time period), but this will be shorter than the time period 19 between adjacent sampling instances in the operational mode, as represented in Figure 3.

Each digital output signal 30a', 30b' may be compared separately to the expected digital output signal 32, and separate calibration corrections (i.e. adjustments) may be stored in relation to each ADC 2a, 2b, 2c, so that each may be calibrated separately. In this way any discrepancies between the different ADCs 2a, 2b, 2c are accounted for.

Stored calibration corrections (adjustments) are then applied to signals which are collected during a subsequent operational period. As seen on the right-hand side of Figure 3, as a result of applying the derived calibrations to each ADC 2a, 2b, 2c separately, the digital output signals 30a, 30b are aligned during normal operation. This allows the overall time-interleaved ADC 1 to provide an improved digital output.

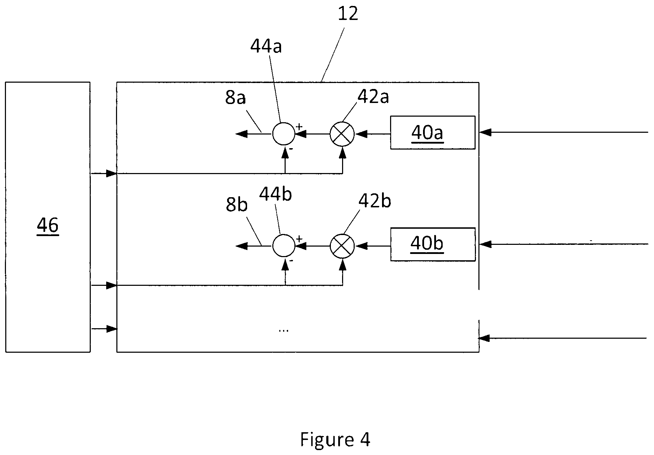

Figure 4 is a schematic diagram of a field programmable gate array 12, demonstrating one possible arrangement to apply the gain and offset calibration corrections calculated according to the method described above with reference to Figure 3.

In this example method raw data 40a, 40b is received from each ADC 2a, 2b, 2c of the time-interleaved ADC 1. Although three ADCs are included in the present example, the ellipsis in Figure 4 is used to illustrate that more or fewer than three ADCs may be present. Separately, gain correction information 42a, 42b and offset correction information 44a, 44b specific to each ADC (i.e. respective calibration corrections) are retrieved from a non-volatile memory 46 of the time-interleaved ADC 1. Gain and offset corrections are then applied respectively to each set of raw data 40a, 40b, based on the ADC 2a, 2b, 2c from which the raw data was received, based specifically on the gain correction information 42a, 42b and offset correction information 44a, 44b relating to that specific ADC 2a, 2b, 2c. The corrected data 8a, 8b, then provides the respective digital output of each ADC 2a, 2b, 2c which is then supplied to the time-interleaving portion 10.

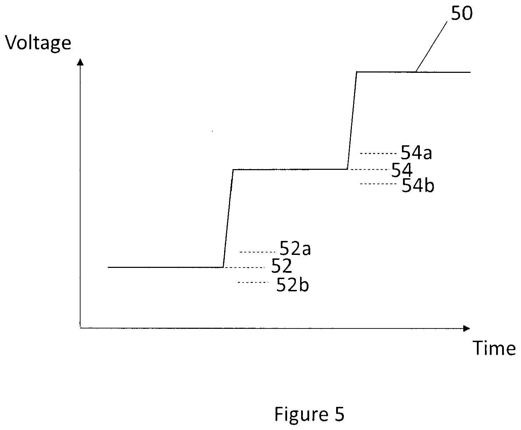

Figure 5 is a graph illustrating an example calibration method using a calibration voltage signal 50. This method may be carried out using sampling of the type described above with respect to Figure 3, or may alternatively be used in addition to such a calibration method (and may be carried out with respective ADCs sampling at different times).

The graph of Figure 5 illustrates the voltage (along the y-axis) of an input analogue calibration signal, referred to as a calibration voltage signal 50, over time (along the x-axis). This calibration voltage signal 50 may be used to calibrate for gain and offset. For example, this may be done initially during set-up of the time-interleaved ADC 1, or may be carried out during the operational life of the device, in order to supplement or improve the calibration process described above, in which no calibration signal is supplied, but in which voltage is sampled during a period in which the expected input signal is known.

In this example, the calibration voltage signal 50, which may also be referred to as a gain-and/or-offset-calibration signal, has a stepped form. It will be appreciated that the calibration voltage signal 50 may have any suitable form and value. In order to determine whether discrepancies arise as a result of offset or gain errors, the calibration voltage signal 50 has at least two different values, at two different times. If only a single value is sampled, a difference between the calibration signal and the obtained digital output could be due either to gain or offset and it would not be possible to determine which.

It can be seen that the calibration voltage signal 50 has a first voltage value 52 at a first time, and a second voltage value 54 at a second time. The first ADC 2a at the first time produces a digital output 52a, which is higher than the value 52 of the calibration voltage signal 50 at that time. Similarly, the digital output 54a at the second time is also higher. This suggests an offset error, which can then be accounted for in the later digital outputs from the first ADC 2a by shifting the output value down by a pre-set amount (i.e. applying this shift as a calibration correction).

Conversely, the digital outputs 52b, 54b from the second ADC 2b are consistently lower than the values 52, 54 of the calibration voltage signal 50, and therefore the digital output of the second ADC 2b is subsequently shifted up during normal operation, to compensate for this offset error.

A supplied calibration signal, of known voltage value, may also be used to calibrate for timing skew between different ADCs. Timing skew refers to a situation in which one ADC does not sample precisely halfway between the sampling times of the preceding and following ADCs, meaning that the sampled values are not collected at equally spaced times. This can distort the produced output signal.

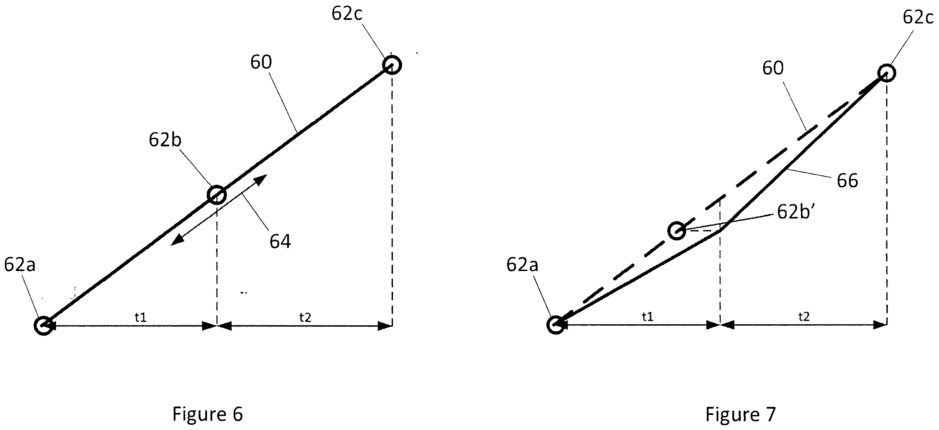

This method is illustrated in greater detail in Figures 6 and 7.

In this example, the calibration voltage signal 60, is a ramped voltage, i.e. a straight line with a non-zero gradient (in this example a positive gradient). This calibration voltage signal 60 may also be referred to as a sloped time-calibration signal.

Figure 6 illustrates the value of the calibration voltage signal 60 over time. The circles 62a, 62b, 62c indicate ideal sampling, times for the ADCs 2a, 2b, 2c. In an ideal world t1 (the time between sampling with the first ADC 2a and the second ADC 2b) and t2 (the time between sampling with the second ADC 2b and the third ADC 2c - or with the second ADC 2b and then the first ADC 2a if only two were present) would be equal. However, timing errors can shift the sampling time of any of the ADCs. In this case, timing shift of the second ADC 2b, as illustrated by a timing skew arrow 64, is used as an example.

Figure 7 illustrates how the calibration voltage signal 60 may be used to detect, and correct, timing skew of the second ADC 2b. In this example, instead of sampling at the desired time, the second ADC 2b is sampling at a skewed time 62b', which is earlier than it should be. These samples produce an overall digital output 66 which is shown with a solid line.

As a result of this timing skew, when the digital outputs of the three ADCs 2a, 2b, 2c are used to reconstruct the calibration voltage signal 60 (i.e. are interleaved by the time-interleaved ADC), instead of producing a uniformly ramped voltage as they should, the data point from the second ADC 2b, which is treated as having been sampled halfway between the first and third samples, causes the digital output 66 to have two separate portions with a pronounced difference in gradient between them.

By calculating the shift in time position which is needed for this data point in order to reconstruct the ramped calibration voltage signal 60, the timing skew of the second ADC 2b may be determined and therefore corrected for in subsequent operation of the time-interleaved ADC 1.

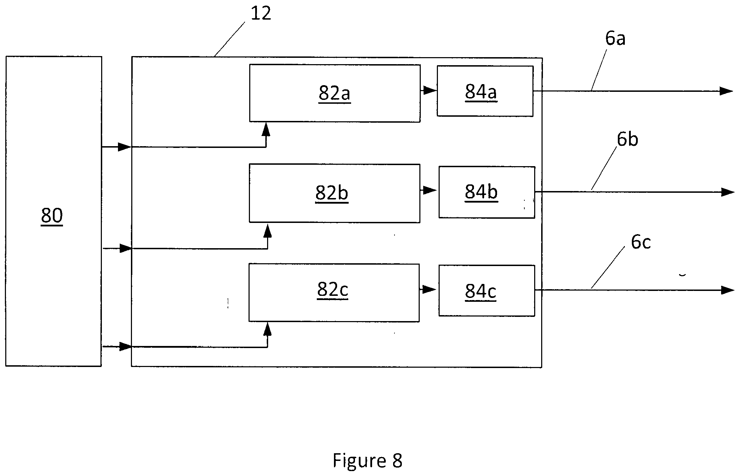

Figure 8 is a schematic diagram of a field programmable gate array 12. Timing errors derived for each ADC 2a, 2b, 2c using the method described above are stored in non-voltage memory 80, which may be the same as the non-volatile memory 46 shown in Figure 4, or may be separate.

These stored timing errors are then used to derive configurable delay values 82a, 82b, 82c which are supplied to respective output buffers or multiplexed output register 84a, 84b, 84c, associated with each ADC. These apply individual delays to the timing signals applied to each ADC separately, so as to delay them by the appropriate amount required to partially (or ideally fully) compensate for the detected timing skew. This adjustment applied to change the timing signal causes a change in the sample timings of the associated analogue-to-digital converter.

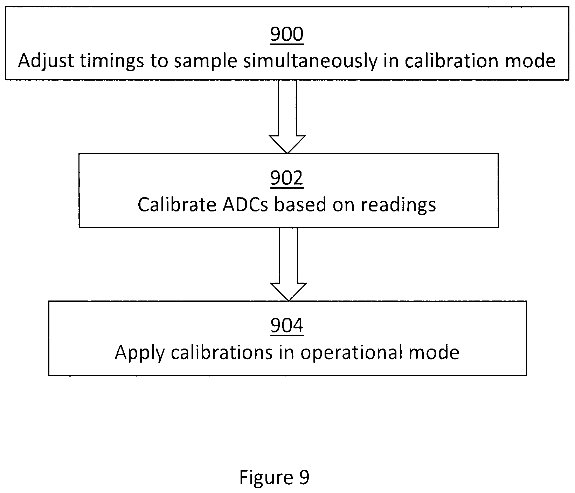

Figure 9 is a flowchart representing a method according to the present disclosure.

First, at stage 900 of this example method, the time-interleaved ADC 1 is operated in a calibration mode. In this mode, the sample timings at which each ADC 2a, 2b, 2c samples the analogue input 4 are adjusted (e.g. by adjusting the timing signals 6a, 6b, 6c) such that the ADCs 2a, 2b, 2c sample the analogue input 4 simultaneously.

Next, at stage 902 of this example method, gain and offset calibrations for the ADCs 2a, 2b, 2c are derived based on the simultaneous sampling. As explained above, the ADCs 2a, 2b, 2c could be made to sample closer together in time but not precisely simultaneously.

Then, at stage 904 of this example method, the ADCs 2a, 2b, 2c are operated in the normal, operational mode, and the derived calibration corrections are applied to the respective digital outputs, e.g. as illustrated on the right-hand side of Figure 3.

It will be appreciated by those skilled in the art that the disclosure has been illustrated by describing one or more specific aspects thereof, but is not limited to these aspects; many variations and modifications are possible, within the scope of the accompanying claims.

## Claims

1. A time-interleaved analogue-to-digital converter comprising:
a first analogue-to-digital converter, arranged to sample an analogue input periodically and produce a digital output based on the sampled analogue input;
a second analogue-to-digital converter, arranged to sample the analogue input periodically and produce a digital output based on the sampled analogue input; and
a signal interleaving portion, arranged to combine the digital outputs from the first analogue-to-digital converter and the second analogue-to-digital converter to produce a digital output signal;
the time-interleaved analogue-to-digital converter configured for operation both in an operational mode and in a calibration mode;
wherein, in the operational mode, the second analogue-to-digital converter is arranged to sample the analogue input a first time period after the first analogue-to-digital converter samples the analogue input; and
wherein, in the calibration mode, the second analogue-to-digital converter is arranged to sample the analogue input simultaneously with the first analogue-to-digital converter sampling the analogue input; or
wherein, in the calibration mode, the second analogue-to-digital converter is arranged to sample the analogue input a second time period apart from a time at which the first analogue-to-digital converter samples the analogue input, wherein the second time period is shorter than the first time period.

2. The time-interleaved analogue-to-digital converter of claim 1, wherein in the calibration mode the second analogue-to-digital converter is arranged to sample the analogue input simultaneously with the first analogue-to-digital converter sampling the analogue input.

3. The time-interleaved analogue-to-digital converter of claim 1 or 2, wherein the time-interleaved analogue-to-digital converter is configured for operation in the calibration mode during a period of time in which an expected value of the analogue input is known.

4. The time-interleaved analogue-to-digital converter of any preceding claim, wherein the time-interleaved analogue-to-digital converter is configured for operation in the calibration mode during power-up of the time-interleaved analogue-to-digital converter.

5. The time-interleaved analogue-to-digital converter of any preceding claim, wherein the time-interleaved analogue-to-digital converter is configured, for a single calibration process, to operate in the calibration mode for a pre-defined time period.

6. The time-interleaved analogue-to-digital converter of any preceding claim, wherein the time-interleaved analogue-to-digital converter is configured to derive respective calibration corrections for the first analogue-to-digital converter and the second analogue-to-digital converter based on the digital outputs of the first analogue-to-digital converter and the second analogue-to-digital converter produced in the calibration mode.

7. The time-interleaved analogue-to-digital converter of claim 6, wherein the time-interleaved analogue-to-digital converter is configured to derive the calibration corrections for each of the analogue-to-digital converters by calculating the adjustment needed to bring the digital outputs of the first and second analogue-to-digital converters into alignment with an expected value of the analogue signal.

8. The time-interleaved analogue-to-digital converter of claims 6 or 7, wherein the time-interleaved analogue-to-digital converter is configured to apply the derived respective calibration corrections to the digital outputs of the first analogue-to-digital converter and the second analogue-to-digital converter during operation in the operational mode.

9. The time-interleaved analogue-to-digital converter of any preceding claim, wherein the time-interleaved analogue-to-digital converter is configured to receive at least one calibration voltage signal at the analogue input.

10. The time-interleaved analogue-to-digital converter of claim 9, wherein the calibration voltage signal comprises a gain-and/or-offset-calibration signal, wherein the gain-and/or-offset-calibration signal has at least two different values, at different times, and wherein the time-interleaved analogue-to-digital converter is configured to derive calibration corrections for gain and/or offset for the first analogue-to-digital converter and the second analogue-to-digital converter based on comparing the digital outputs of the first analogue-to-digital converter and the second analogue-to-digital converter with the corresponding value of the gain-and/or-offset-calibration signal.

11. The time-interleaved analogue-to-digital converter of claim 9 or 10, wherein the calibration voltage signal comprises a sloped time-calibration signal, wherein the time-interleaved analogue-to-digital converter is configured to derive a timing correction for the first analogue-to-digital converter and/or the second analogue-to-digital converter based on comparing digital outputs of the first analogue-to-digital converter and the second analogue-to-digital converter, output based on samples of the time-calibration signal taken at different times.

12. The time-interleaved analogue-to-digital converter of claim 11, further configured to adjust sample timings at which the first analogue-to-digital converter and/or the second analogue-to-digital converter sample the analogue input based on the derived timing corrections.

13. A time-interleaved analogue-to-digital converter calibration system, comprising:
the time-interleaved analogue-to-digital converter of any of claims 9 to 12; and
a voltage source, arranged to supply the at least one calibration voltage signal to the analogue input of the time-interleaved analogue-to-digital converter.

14. A method of operating a time-interleaved analogue-to-digital converter, the time-interleaved analogue-to-digital converter comprising:
a first analogue-to-digital converter, arranged to sample an analogue input periodically according to a first set of sample timings and produce a digital output based on the sampled analogue input;
a second analogue-to-digital converter, arranged to sample the analogue input periodically according to a second set of sample timings and produce a digital output based on the sampled analogue input; and
a signal interleaving portion, arranged to combine the digital outputs from the first analogue-to-digital converter and the second analogue-to-digital converter to produce a digital output signal;
comprising:
in a calibration mode, adjusting the first set of sample timings and/or the second set of sample timings such that the first analogue-to-digital converter and the second analogue-to-digital converter sample the analogue input closer together in time than during normal operation of the time-interleaved analogue-to-digital converter.

15. The method of claim 14, comprising operating the time-interleaved analogue-to-digital converter in the calibration mode during power-up of the time-interleaved analogue-to-digital converter.
